# EUROPEAN PATENT APPLICATION

(11) **EP 2 058 835 A1**
(43) Date of publication of application: **13.05.2009**
(21) Application number: 07120434.1
(22) Date of filing: 12.11.2007
(51) Int. Cl.: H01J 37/21, G01R 31/307, G02B 21/00

(54) **Autofocussing method**

(71) Applicant: FEI COMPANY, Hillsboro, Oregon 97124-5793 (US)
(72) Inventor: Faber, Jacob, 5627 KH, Eindhoven (NL)
(74) Representative: Bakker, Hendrik

(57) **Abstract**

The invention relates to a method for focusing an object in e.g. a scanning electron microscope. A first image of an object is acquired using a first focal value F₁, and the defocus dF₁ of the image is estimated by comparing the image with a series of through-focus images of a master object. Said through-focus series comprises images of similar areas of another, similar object. The focus of the SEM is now corrected by setting the focal value to F₁ - dF₁. However, as known to the person skilled in the art, there is a chance that the correct value is F₁ + dF₁, as equal amounts of under- and over focus give very similar images. Therefore the defocus is estimated again, and when the defocus is larger than the first defocus, the focal value is set to F₁ + dF₁.

## Description

The invention relates to a method for forming a focused image of an object by an apparatus, the apparatus equipped with a focusing device capable of being set to different focal values, the method comprising: deriving a through-focus series of images of a master object similar to the object to be imaged, each image of the series of images associated with a defocus value, setting the focal value to a first focal value F₁, obtain a first image of the object, comparing the image with the through focus series of images and determining an estimate of a first defocus value dF₁, and changing the focus to a second focal value F₂ = F₁ - dF₁.
The invention further relates to software for programming a programmable controller of an apparatus, the apparatus equipped with a focusing device capable of being set to different focal values, the software comprising code for programming the apparatus to perform the method.

Such a method is known from "Simfit and Focus Diversity: methods for determining the focus of the SIRTF telescope in space without a focus slew", W.F. Hoffmann et al., Proceedings of SPIE IR Space Telescopes and Instruments, Volume 4850, pp. 428-440, March 2003.

In the mentioned paper a focusing method is described for a space based telescope. The telescope is diffraction limited. To minimise possible lock-up of the focusing mechanism in space, focus determination should be achieved without the conventional focus slew. The Simfit method described involves forming a series of simulated point-source images for a range of focus settings, using a model for the (aberrations of the) telescope. An obtained image is then compared with the series of simulated images to determine the defocus value. The defocus value thus determined can then be used to focus the telescope. The method was successfully used to focus the Spitzer Space Telescope (see "The state of focus and image quality of the Spitzer Space Telescope as measured in orbit", R.D. Gehrz et al., Proceedings of the SPIE Optical, Infrared, and Millimeter Space Telescopes, Volume 5487, pp. 166-176, Oct 2004).

The known method compares an image of a object, such as a star, with a series of images representing the simulated response of the telescope for a point source at different defocus settings.
In this context a point source is an object that is so small that its geometrical image is much less than the optimum resolution of the image formed.
The series of images representing the simulated response are obtained by ray-tracing.
Comparing the image with the series of images representing the simulated response gives a 'best fit' and an estimate of the defocus. By correcting the focal setting by the defocus value of the telescope thus estimated the telescope is focused.

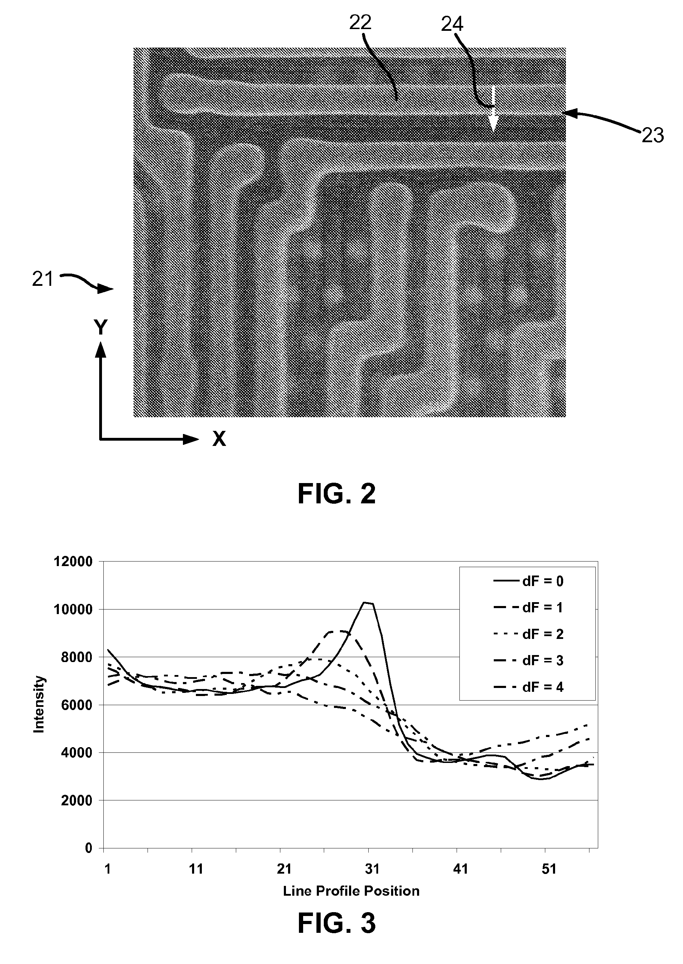

A disadvantage of the known method is that it shows good results for focusing a diffraction limited telescope imaging stars, but that it does not provide a solution for objects that are not point sources. As known to the person skilled in the art, a star can for all practical cases be treated as a point source. As also known the series of images representing the simulated response to a point source are a series of images of the optical aberrations of the telescope, which can be derived from a model of the telescope. However, in the case that the object is not a point-source, and the image is at least partially determined by the extend of the object the series of images representing the simulated response of the telescope for a point source do not match the image.
This is also hinted at in the known paper, in the text accompanying figure 2, where it says that a secondary peak on the opposite side of best focus is shown, where the image is similarly blurred from defocus, but has a very different structure. However, when imaging objects that are not point sources, the "very different structure" only contributes to image changes in a minor way and it may be difficult to distinguish between the two peaks.

Another disadvantage is that the method is very sensitive for the model used to determine the through-focus series. In section 5 of the known document two methods for focusing the telescope are discussed (Simfit and Focus Diversity), and it states that "Simfit is most sensitive to model error, Focus Diversity to random noise". For a diffraction limited telescope the aberrations may be known with sufficient precision, but this need not be the case for other instruments. When using e.g. a scanning electron microscope (SEM), where the aberrations depend on many variables, such as beam energy, spot size, scan speed, scan distortion, setting of the stigmator, distance between objective lens and object, interference by stray magnetic fields, etc., the appearances (e.g. form and/or magnitude) of these aberrations are often not sufficiently known, although they reproduce from image to image.

It is an object of the invention to provide an improved focusing method.

To that end the method according to the invention is characterized in that
- the master object is not a point-source,
- a second image is formed,
- an estimate of a second defocus value is determined using a focus criterion, and,
- if the absolute value of the second defocus value is larger than the absolute value of the first defocus value dF₁, the focal value is set to F₃ = F₁ + dF₁.

Inventor applied the known method to images made using a Scanning Electron Microscope, comparing an image of an object with a through-focus series of images from the same or a similar object. It was found, as mentioned before, that for non-point sources the sign of the defocus cannot be determined reliably, as equal amounts of under- and over focus give very similar images. As a result there is a chance that, when changing the focal value F₁ to F₂ = F₁ - dF₁, the correction is in the wrong direction and the absolute value of the defocus becomes twice as large.
By now determining the defocus value in the second image formed, it is determined whether the focal value F₁ is set to the correct focal value. If this is not the case, the focal value is set to the correct value, that is: the focal value is set to F₃ = F₁ + dF₁.

In an embodiment of the method according to the invention the sign of dF₁ is set to a positive or a negative value before F₂ is set.

Inventor found that for many applications, e.g. applications using a SEM, the chance that the estimated value for the defocus F1 has the correct sign is about 50%. In this case the sign of the estimated value does not influence the chance to arrive at the correct value, so that it makes as much sense to change the focus to a smaller focal value as to change the focus to a larger focal value. The sign can thus be neglected. This is especially useful as the acquired image need only be compared to a series of images where no images corresponding with a positive defocus value are present, or where no images corresponding with a negative defocus value are present, thereby reducing the number of comparisons necessary.

In another embodiment of the method according to the invention the sign of dF1 is inverted before F₂ is set.

Effectively this means that, instead of setting F₂ to the value F₂ = F₁ - dF₁, F₂ is set to the value F₂ = F₁ + dF₁, and instead of setting F₃ to the value F₃ = F₁ + dF₁, F₃ is set to the value F₃ = F₁ - dF₁. So, instead of using a subtraction an addition may be used, as long as addition is used where originally a subtraction is used.

In yet another embodiment of the method according to the invention the image is formed by scanning a probe over the object.

As already mentioned inventor used the method according to the invention for imaging objects in a SEM. In such an instrument a field of view is scanned with a probe of focused electrons. The method is especially advantageous for this type of instruments, as it is possible to achieve the correct setting of the focal value with a reduced field-of-view and/or at higher scan speed than when making the image of the object that is used for inspection or analysis. This makes an apparatus POSSIBLE capable of achieving high throughput for inspecting the quality of e.g. dies on a semiconductor wafer, measuring critical dimensions on a die, or inspecting critical dimensions during the production of heads used in hard-disk drives.

In a further embodiment of the method according to the invention the image is a line scan.

When measuring critical dimensions the object often shows a bar or track in one direction, in which e.g. the width of the bar or track is the critical dimension. By scanning a line in a direction perpendicular to this bar or track, a minimum of scan time, and thus process time, is used to obtain an image that can be used to focus.

It is noted that the critical dimension is often measured using a frame with a multitude of lines at slightly different positions, so that 'the' critical dimension can be determined, after focusing, by averaging over this multitude of lines. However, this frame need not be used for focusing, thereby offering a focusing method using less data points and thus improved processing time.

In another embodiment of the method according to the invention the focus criterion is determined by comparing the second image with the through focus series of images.

In this embodiment the defocus of the second image can be determined by comparing it with the through-focus series of images.

In yet another embodiment of the method according to the invention the focus criterion is determined from features from the second image only.

In this embodiment the defocus is estimated from features present in the second image itself. Such a criterion can be e.g. the rise time of a contrast signal while scanning over a bar.

In still another embodiment of the method according to the invention the apparatus is a particle-optical apparatus.

The method can be used in e.g. a SEM, or an apparatus in which a beam of ions is focused on an object.

In yet another embodiment of the method according to the invention the focus value F₁ is only set to a different focus value F₂ when the defocus dF₁ is larger than a predetermined value.

If the first image is already sufficiently in focus, there is no need to change the focus.

In another embodiment of the method according to the invention the through-focus series of images of the master object is obtained by imaging the master object

Inventor used for his experiments a through-focus series of images made from a master object similar to the object to be imaged. This embodiment is especially useful for focusing e.g. semiconductor structures or the heads of hard disk drives during manufacturing said heads.

In a further embodiment of the method according to the invention the object and the master object form two positions on a larger object.

The larger object may e.g. be a wafer, or a mask as used during wafer manufacturing.

This embodiment describes the application of the method on e.g. semiconductor wafers, where many similar structures must be imaged so that e.g. defects can be found.

In another embodiment of the method according to the invention the through-focus series of images is obtained by simulation, using at least a model representing the master object.

The through-focus series of images may also be a simulated series of images. The simulated series can be based on a series of images obtained from a known object and 'translating' it to the master object to be used for the series of images, e.g. because the known object and the master object differ in shape (the known object and the master object may e.g. be mirror images). The simulated series may also be based on a model of both the object (e.g. a CAD model) and the optics of the apparatus forming the image.

In yet another embodiment of the method according to the invention the through-focus series does not comprise images with a positive defocus or does not comprise images with a negative defocus

Especially in the cases where the blurring of the image for a positive defocus is similar to the blurring of the image of a negative defocus, sign of the defocus is neglected, there is no reason to compare the first image for each defocus setting of the series of through-focus images with two images, one with a positive defocus and the other with a negative defocus.

In still another embodiment of the method according to the invention a multitude of images is made on different positions of the object, and the defocus value is determined by estimating the defocus value for each of the images, and a defocus value of the object is estimated by combining the defocus values for each of the images.

This embodiment is especially beneficial when the object might show imperfect features or dust particles on some parts of the object.
It is noted that the areas from which the images are formed need not have identical aspect ratios.
It is further noted that the defocus value of the object may be found by e.g. taking the average of the defocus values of the different areas, but that it may also be found by disregarding a part of the defocus values as they show a value which is markedly different from the defocus values of other areas.

An aspect of the invention relates to software for programming a controller of an apparatus, the apparatus equipped with a focusing device capable of being set to different focal values, the software comprising code for programming the apparatus to perform the method according to the invention.

As known to the person skilled in the art, such software can be stored on a computer readable medium, e.g. a CD or a DVD, but may also reside on a server computer and be interchanged between said server and the apparatus by e.g. internet.

The invention is now further elucidated on the basis of schematic drawings, where corresponding features are identified by identical numerals. To this end:
figure 1 schematically shows a flow diagram of the method according to the invention,
figure 2 shows an image of an object in a SEM,
figure 3 schematically shows a series of through-focus line scans over the object shown in figure 1, and
figure 4 shows multiple line scans made on the object in a SEM.

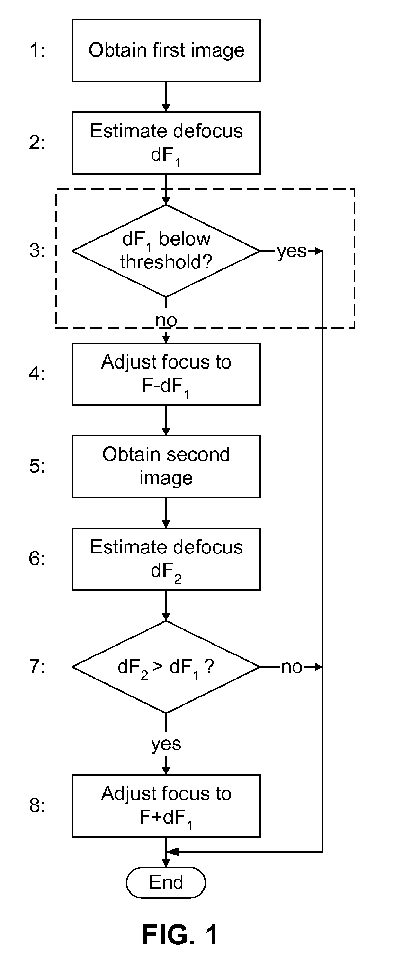

Figure 1 schematically shows a flow diagram of the method according to the invention.
Before the part of the method shown in the flow chart is executed, a through-focus series of the master object is obtained.
In step 1 a first image of the object is made using a focal value F₁. The first image may be a line scan, but it may also be a 2D image of (part of the) object. It will be clear that it must be similar to the images of the through-focus series obtained of the master object, imaging an area with the same aspect ratio and a same area.
In step 2 the defocus of the first image dF₁ is estimated by comparing it with the through-focus series of the master object.
Optional step 3 determines whether the defocus is already so small that no further focusing is needed. Whether this is attractive depends on how likely it is that the object is sufficiently in focus.
In step 4 the focus is adjusted by the defocus value found in step 2 to F₂ = F₁-dF₁.
In step 5 a second image is acquired. This second image is preferably the same area, or nominally the same area, as imaged in the first image, but it may be a different area comprising an identical feature, such as a slightly different part of a track on a semiconductor sample.
In step 6 the defocus of the second image is estimates. It may be estimated by comparison with the through-focus series of the master object, but it may also be estimated on the hand of information present in the second image, e.g. by determining a FWHM width of the peak in the image or the 80/20 contrast change in the image of a track.
In step 7 the defocus value of the second image is compared to the defocus value of the first image. If it is larger, then the adjustment of the focus in step 4 caused a larger defocus. Alternatively the defocus can be compared to a threshold value as used in step 3.
In step 8 the focus is adjusted to a value of F₁ + dF₁, which should be the correct value.

It is noted that optionally the defocus can be determined after step 8 to determine whether proper focusing of the object occurred, or whether this was hindered by e.g. dust particles on the object or imperfections of features on the object.

Figure 2 shows an image of an object in a Scanning Electron Microscope (SEM). It shows a (focused) image 21 of a semiconductor sample with a track 22 on its surface. In a SEM the sample is scanned with a finely focused beam of electrons. The impinging electrons cause e.g. secondary electrons to emanate from the sample. By detecting the secondary electrons the image is made. As can be seen the track 22 shows, in the focused image, a well-defined intensity change at position 23. Such an intensity change is representative for many well-focused features on numerous samples. By making one or more line scans 24 over this edge a first image is made. This first image is then compared with a through-focus series of a master object and the associated defocus is determined.
It is noted that the first image may be a 2D image of several lines 24 side-by-side, to be compared with a through-focus series of 2D images, but depending on the sample better results may be achieved using e.g. a single line scan along line 24, or a summation or average of several line scans along line 24, or the summation or average of several line scans displaced in the x-direction.

Figure 3 schematically shows a through-focus series of line scans over the object shown in figure 2. It shows for different defocus values the intensity as a function of the position along the scan line, that is: along the line 5 as shown in figure 1. This may thus be the through-focus series of the master object. The intensity and defocus value are given in arbitrary units, and the line scan comprises some 57 discrete positions along line 5 of figure 1. Here a set of 5 intensity profiles are given, from best focus (dF = 0) to well out of focus (dF = 4).

Depending on how well the sample is focused, an image of the object to be focused will resemble one of these intensity profiles. By comparing the image of the object with the through-focus set, the defocus of the object is estimated.

It is noted that comparing can comprise e.g. simple subtraction of the intensity profiles, but may also include more sophisticated methods, such as methods comprising e.g. peak detection of the amplitude along the scan line, search for a gradient in the amplitude, or e.g. correlation techniques.

It is further noted that the through-focus series may represent a larger or a smaller area or line scan than the image of the object, as this gives good results while correlating the image with the through focus series (provided that e.g. proper padding is done by adding e.g. zero's).

It is also noted that, although the example show only 5 curves associated with 5 different defocus values, in reality many more curves may be used.

It is also noted that, although here the through-focus series is made on the hand of images made with a SEM of a master object, it is also possible to construct a through-focus series on the hand of models of the SEM and the master object, without forming a series of actual images. This simulation of the through-focus series can use e.g. a CAD model of the object.
It is also possible that the through-focus series is e.g. made using multiple line scans and adding or averaging the multiple line scans so as to improve the signal-to-noise ratio. Another possibility is that the method is used to obtain the defocus value of several line scans and take the average of the obtained defocus values. This is especially advantageous when the object may show irregularities at the scanned edge that may result in a line scan with reduced intensity step function.

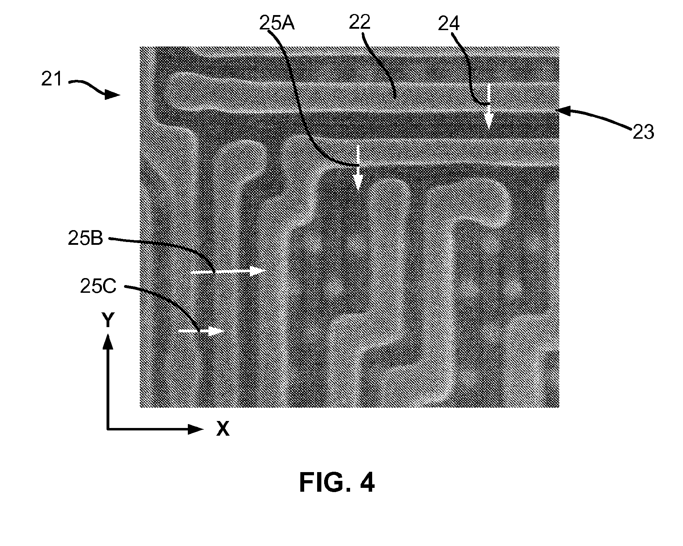

Figure 4 shows multiple line scans made on the object in a SEM.
Figure 4 can be thought to be derived from figure 2. Here however not one image 24 is made to determine the defocus value, but several images (here in the form of line scans) 25A, 25B and 25C are made to determine the defocus value. For each of the images 24, 25A, 25B and 25C a defocus value is estimated by comparing it with a through-focus series of a similar area of the master object, and the defocus value for the object is determined by combining the defocus value found for each of the areas. This is especially beneficial when the object might show imperfect features or dust particles on some parts of the object.
It is noted that the areas from which the images are formed need not have identical aspect ratios.
It is further noted that the defocus value of the object may be found by e.g. taking the average of the defocus values of the different areas, but that it may also be found by disregarding a part of the defocus values found if they show a value which is markedly different from the defocus values of other areas.

## Claims

1. Method for forming a focused image of an object with an apparatus, the apparatus equipped with a focusing device capable of being set to different focal values, the method comprising:
• obtaining a through-focus series of images of a master object, said master object similar to the object to be imaged, each image of the series of images associated with a defocus value,
• setting the focal value to a first focal value F₁,
• obtain a first image of the object (1),
• comparing the image with the through-focus series of images and determining an estimate of a first defocus value dF₁ (2), and
• setting the focus to a second focal value F₂ = F₁ - dF₁ (4),
**characterized in that**
• the master object is not a point-source,
• a second image is formed (5),
• an estimate of a second defocus value is determined using a focus criterion (6), and
• if the absolute value of the second defocus value is larger than the absolute value of the first defocus value dF₁ (7), the focal value is set to F₃ = F₁ + dF₁ (8).

2. The method according to claim 1 in which the sign of dF₁ is set to a positive or a negative value before F₂ is set.

3. The method according to claim 1 in which the sign of dF₁ is inverted before F₂ is set.

4. The method according to any of the preceding claims in which the first and the second images are formed by scanning a probe over the object.

5. The method according to claim 4 in which the first and the second images are line scans (24, 25A, 25B, 25C).

6. The method according to any of the preceding claims in which the focus criterion is determined by comparing the second image with the through-focus series of images.

7. The method according to any of claims 1-5 in which the focus criterion is determined from features from the second image only.

8. The method according to any of the preceding claims in which the apparatus is a particle-optical apparatus.

9. The method according to any of the preceding claims in which the focus value F₁ is only set to a different focus value F₂ when the defocus dF₁ is larger than a predetermined value (3).

10. The method according to any of the preceding claims in which the through-focus series of images of the master object is obtained by imaging the master object.

11. The method according to claim 10 in which the object and the master object form two positions on a larger object.

12. The method according to any of claims 1-9 in which the through-focus series of images is obtained by simulation, using at least a model representing the master object.

13. The method according to any of the preceding claims in which the through focus series does not comprise images with a positive defocus or does not comprise images with a negative defocus.

14. The method according to any of the preceding claims in which a multitude of images (24, 25A, 25B, 25C) is made on different positions of the object, and the defocus value is determined by estimating the defocus value for each of the images, and a defocus value of the object is estimated by combining the defocus values for each of the images.

15. Software for programming a programmable controller of an apparatus, the apparatus equipped with a focusing device capable of being set to different focal values, the software comprising code for programming the apparatus to perform the method according to any of the preceding claims.
